(19)

**Europäisches Patentamt**
**European Patent Office**
**Office européen des brevets**

(11) **EP 3 392 907 B1**

(12) **EUROPEAN PATENT SPECIFICATION**

(45) Date of publication and mention
of the grant of the patent:
**03.07.2019 Bulletin 2019/27**

(51) Int Cl.:
**H01L 23/373** (2006.01)     **H01L 23/495** (2006.01)

(21) Application number: **18160935.5**

(22) Date of filing: **09.03.2018**

(54) **SEMICONDUCTOR DEVICE**

HALBLEITERBAUELEMENT

DISPOSITIF À SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.04.2017 JP 2017083063**

(43) Date of publication of application:
**24.10.2018 Bulletin 2018/43**

(73) Proprietor: **Kabushiki Kaisha Toshiba Minato-ku, Tokyo (JP)**

(72) Inventors:
• **Sasaki, Akihiro**
**Tokyo (JP)**
• **Iguchi, Tomohiro**
**Tokyo (JP)**
• **Kimura, Akiya**
**Tokyo (JP)**

(74) Representative: **Hoffmann Eitle Patent- und Rechtsanwälte PartmbB Arabellastraße 30 81925 München (DE)**

(56) References cited:
**JP-A- 2016 134 586**     **JP-A- 2017 139 345**
**US-A1- 2012 138 946**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD

Embodiments relate to a semiconductor device.

BACKGROUND

The power semiconductor chip generates high heat during operation. High heat deforms a semiconductor device such as a power semiconductor module. Improvement in heat dissipation is desired. US 2012/138946 A1 discloses a semiconductor device on which the preamble of claim 1 is based. A similar semiconductor device is disclosed in JP 2016 134586 A.

BRIEF DESCRIPTION OF THE DRAWINGS

FIG. 1 is a schematic sectional view illustrating a semiconductor device according to a first example useful for understanding the invention;
FIG. 2A is a schematic plan view illustrating a semiconductor device according to the first example;
FIG. 2B is a schematic sectional view taken along line B-B in FIG. 2A; and FIG. 2C is a schematic sectional view taken along line C-C in FIG. 2A;
FIG. 3A is a schematic plan view illustrating a semiconductor device according to the first example;
FIG. 3B is a schematic sectional view taken along line B-B in FIG. 3A; and FIG. 3C is a schematic sectional view taken along line C-C in FIG. 3A;
FIG. 4 is a schematic sectional view illustrating a semiconductor device according to the first example;
FIG. 5 is another schematic sectional view illustrating a semiconductor device according to the first example;
FIGS. 6A and 6B are schematic sectional views illustrating a semiconductor device according to a second example useful for understanding the invention;
FIG. 7 is a schematic plan view illustrating a semiconductor device according to a third example useful for understanding the invention;
FIGS. 8A to 8D are schematic plan views illustrating a semiconductor device according to a fourth example useful for understanding the invention;
FIG. 9 is a schematic plan view illustrating a semiconductor device according to a fifth example useful for understanding the invention;
FIG. 10A is a schematic plan view illustrating a semiconductor device according to an example useful for understanding the invention; and FIG. 10B is a schematic sectional view taken along line B-B in FIG. 10A;
FIG. 11 is another schematic sectional view illustrating a semiconductor device according to the embodiment; and
FIG. 12 is a schematic sectional view illustrating a semiconductor device according to a sixth example useful for understanding the invention.

DETAILED DESCRIPTION

A semiconductor device according to an embodiment includes the features of claim 1. Further, embodiments are named in the dependent claims.
Embodiments of the invention will now be described with reference to the drawings.
The drawings are schematic or conceptual; and the relationships between the thicknesses and widths of portions, the proportions of sizes between portions, etc., are not necessarily the same as the actual values thereof. The dimensions and/or the proportions may be illustrated differently between the drawings, even in the case where the same portion is illustrated.
In the drawings and the specification of the application, components similar to those described thereinabove are marked with like reference numerals, and a detailed description is omitted as appropriate.

(First example useful for understanding the invention)

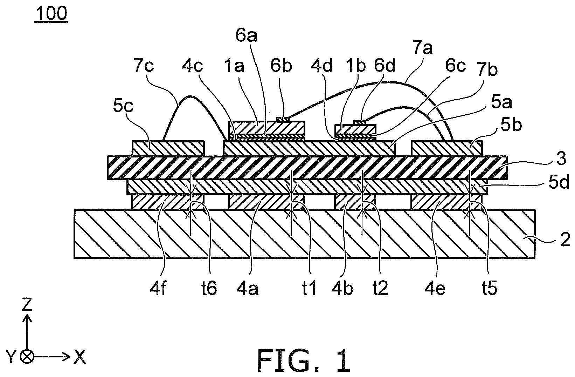

FIG. 1 is a schematic sectional view illustrating a semiconductor device according to a first embodiment.
FIG. 1 shows a first direction, a second direction, and a third direction. In this specification, the first direction is the X-axis direction. The second direction is defined as one direction crossing, e.g. being orthogonal to, the X-axis direction. The second direction is the Z-axis direction. The third direction is defined as one direction crossing, e.g. being orthogonal to, each of the X-axis direction and the Z-axis direction. The third direction is the Y-axis direction. The third direction crosses a plane formed by the first direction and the second direction (a plane including the first direction and the second direction).

As shown in FIG. 1, the semiconductor device 100 includes a first semiconductor chip 1a, a second semiconductor chip 1b, a metal substrate 2, an insulating substrate 3, a first bonding member 4a, and a second bonding member 4b.

The semiconductor device 100 shown in FIG. 1 is e.g. a power semiconductor module. The first semiconductor chip 1a and the second semiconductor chip 1b are power semiconductor chips. The range of current density of the power semiconductor module is e.g. not less than 50 A/cm$^2$ and not more than 1000 A/cm$^2$. The first semiconductor chip 1a is provided with e.g. a transistor. Examples of the transistor include e.g. MOSFET and IGBT. The gate insulating film of the MOSFET is not limited to e.g. oxide. The second semiconductor chip 1b is provided with e.g. a diode. The second semiconductor chip 1b is spaced from the first semiconductor chip 1a in the X-axis direction.

The metal substrate 2 is spaced from the first semiconductor chip 1a and the second semiconductor chip 1b in the Z-axis direction. The metal substrate 2 contains e.g. copper or aluminum.

The insulating substrate 3 is provided between the first semiconductor chip 1a and the metal substrate 2 and between the second semiconductor chip 1b and the metal substrate 2. The insulating substrate 3 contains e.g. at least one selected from the group consisting of alumina, silicon nitride, aluminum nitride, and boron nitride.

The first bonding member 4a is provided between the metal substrate 2 and the insulating substrate 3. At least part of the first bonding member 4a is located between the first semiconductor chip 1a and the metal substrate 2 in the Z-axis direction. The second bonding member 4b is provided between the metal substrate 2 and the insulating substrate 3. At least part of the second bonding member 4b is located between the second semiconductor chip 1b and the metal substrate 2 in the Z-axis direction. The first bonding member 4a and the second bonding member 4b bond the metal substrate 2 to the insulating substrate 3. The first bonding member 4a is located e.g. immediately below the first semiconductor chip 1a in the Z-axis direction. The second bonding member 4b is located e.g. immediately below the second semiconductor chip 1b in the Z-axis direction. A specific example of "immediately below" is described in the following.

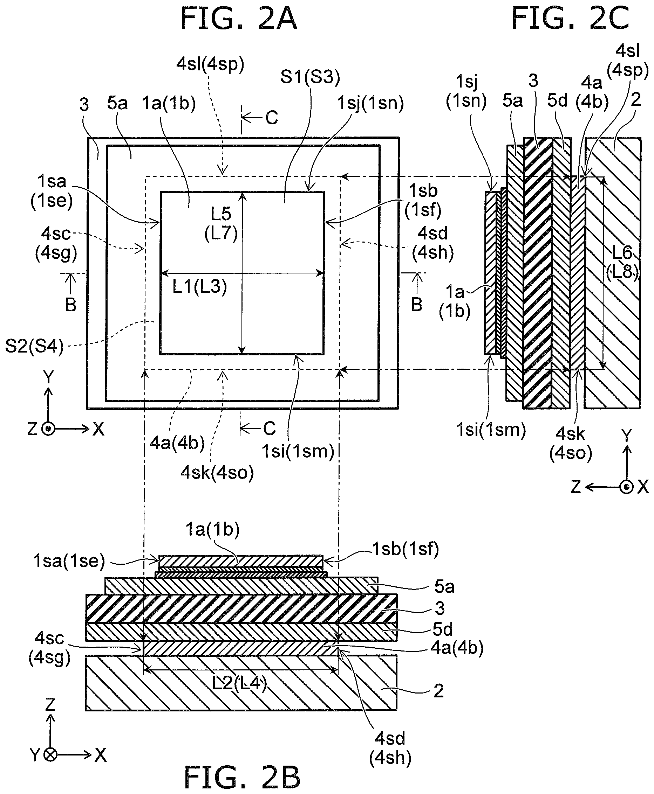

FIG. 2A is a schematic plan view illustrating a semiconductor device according to the first example useful for understanding the invention. FIG. 2B is a schematic sectional view taken along line B-B in FIG. 2A. FIG. 2C is a schematic sectional view taken along line C-C in FIG. 2A. FIGS. 2A to 2C show the portion of the first semiconductor chip 1a or the second semiconductor chip 1b in an enlarged view. The parenthesized reference numerals in FIGS. 2A to 2C represent the case of the second semiconductor chip 1b and the second bonding member 4b.

In the example shown in FIGS. 2A and 2B, the first length L1 of the first semiconductor chip 1a in the X-axis direction is shorter than the second length L2 of the first bonding member 4a in the X-axis direction (L1 < L2). The X-axis direction is e.g. one of the directions parallel to a plane orthogonal to the Z-axis direction. The third length L3 of the second semiconductor chip 1b in the X-axis direction is shorter than the fourth length L4 of the second bonding member 4b in the X-axis direction (L3 < L4). The fifth length L5 of the first semiconductor chip 1a in the Y-axis direction is shorter than the sixth length L6 of the first bonding member 4a in the Y-axis direction (L5 < L6). The Y-axis direction is e.g. one of the directions parallel to a plane orthogonal to the Z-axis direction. The seventh length L7 of the second semiconductor chip 1b in the Y-axis direction is shorter than the eighth length L8 of the second bonding member 4b in the Y-axis direction (L7 < L8).

The first semiconductor chip 1a includes a first side surface 1sa and a second side surface 1sb. The direction from the first side surface 1sa to the second side surface 1sb is parallel to a plane (XY plane) orthogonal to the Z-axis direction, and is e.g. the X-axis direction. The first bonding member 4a includes a third side surface 4sc and a fourth side surface 4sd. The direction from the third side surface 4sa to the fourth side surface 4sd lies along e.g. the X-axis direction.

The second semiconductor chip 1b includes a fifth side surface 1se and a sixth side surface 1sf. The direction from the fifth side surface 1se to the sixth side surface 1sf is e.g. the X-axis direction. The second bonding member 4b includes a seventh side surface 4sg and an eighth side surface 4sh. The direction from the seventh side surface 4sg to the eighth side surface 4sh lies along e.g. the X-axis direction.

The first semiconductor chip 1a includes a ninth side surface 1si and a tenth side surface 1sj. The direction from the ninth side surface 1si to the tenth side surface 1sj is e.g. the Y-axis direction. The first bonding member 4a includes an eleventh side surface 4sk and a twelfth side surface 4sl. The direction from the eleventh side surface 4sk to the twelfth side surface 4sl lies along e.g. the Y-axis direction.

The second semiconductor chip 1b includes a thirteenth side surface 1sm and a fourteenth side surface 1sn. The direction from the thirteenth side surface 1sm to the fourteenth side surface 1sn is e.g. the Y-axis direction. The second bonding member 4b includes a fifteenth side surface 4so and a sixteenth side surface 4sp. The direction from the fifteenth side surface 4so to the sixteenth side surface 4sp lies along e.g. the Y-axis direction.

The first length L1 is shorter than the second length L2, and the fifth length L5 is shorter than the sixth length L6. In this case, e.g. the position of the first side surface 1sa of the first semiconductor chip 1a in the X-axis direction and the position of the second side surface 1sb in the X-axis direction are located between the position of the third side surface 4sc and the position of the fourth side surface 4sd of the first bonding member 4a in the X-axis direction. For instance, the position of the ninth side surface 1si of the first semiconductor chip 1a in the Y-axis direction and the position of the tenth side surface 1sj in the Y-axis direction are located between the position of the eleventh side surface 4sk of the first bonding member 4a in the Y-axis direction and the position of the twelfth side surface 4sl in the Y-axis direction. The four side surfaces of the first semiconductor chip 1a, i.e. the first side surface 1sa, the second side surface 1sb, the ninth side surface 1si, and the tenth side surface 1sj, are each located above the first bonding member 4a in the Z-axis direction.

The third length L3 is shorter than the fourth length L4, and the seventh length L7 is shorter than the eighth length L8. In this case, e.g. the position of the fifth side surface 1se of the second semiconductor chip 1b in the X-axis direction and the position of the sixth side surface 1sf in the X-axis direction are located between the position of the seventh side surface 4sg of the second bonding member 4b in the X-axis direction and the position of the eighth side surface 4sh in the X-axis direction. For instance, the position of the thirteenth side surface 1sm of the second semiconductor chip 1b in the Y-axis direction and the position of the fourteenth side surface 1sn in the Y-axis direction are located between the position of the fifteenth side surface 4so of the second bonding member 4b in the Y-axis direction and the position of the sixteenth side surface 4sp in the Y-axis direction. The four side surfaces of the second semiconductor chip 1b, i.e. the fifth side surface 1se, the sixth side surface 1sf, the thirteenth side surface 1sm, and the fourteenth side surface 1sn, are each located above the second bonding member 4b in the Z-axis direction.

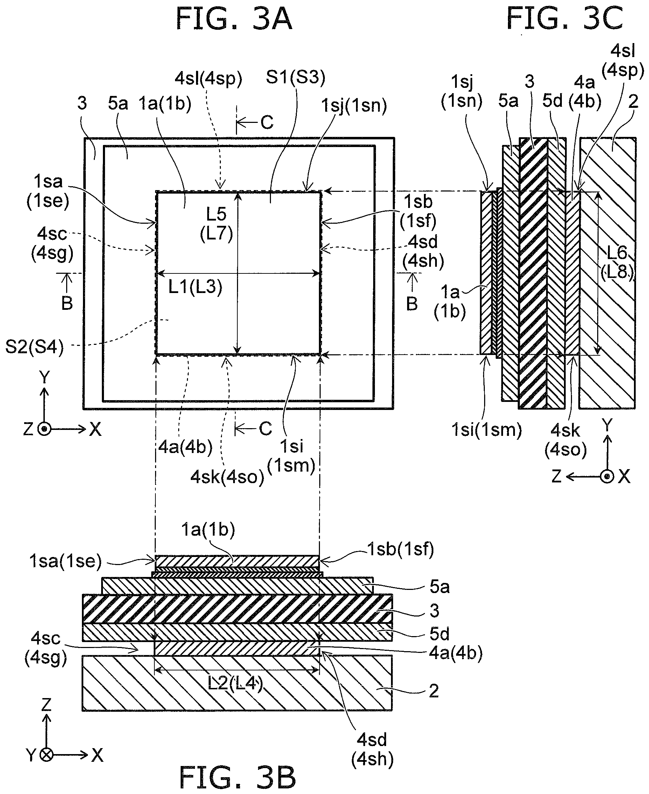

FIG. 3A is a schematic plan view illustrating a semiconductor device according to the first example useful for understanding the invention. FIG. 3B is a schematic sectional view taken along line B-B in FIG. 3A. FIG. 3C is a schematic sectional view taken along line C-C in FIG. 3A.

FIGS. 3A to 3C show the case where the first length L1 is equal to the second length L2 (L1 = L2), and the fifth length L5 is equal to the sixth length L6 (L5 = L6). Alternatively, FIGS. 3A to 3C show the case where the third length L3 is equal to the fourth length L4 (L3 = L4), and the seventh length L7 is equal to the eighth length L8 (L7 = L8). In this specification, the term "equal" includes not only the case of being perfectly equal, but also the case of being substantially equal.

In this case, e.g. the positions of the first side surface 1sa, the second side surface 1sb, the ninth side surface 1si, and the tenth side surface 1sj of the first semiconductor chip 1a overlap the positions of the third side surface 4sc, the fourth side surface 4sd, the eleventh side surface 4sk, and the twelfth side surface 4sl of the first bonding member 4a in the Z-axis direction, respectively. The four side surfaces of the first semiconductor chip 1a, i.e. the first side surface 1sa, the second side surface 1sb, the ninth side surface 1si, and the tenth side surface 1sj, are each located above the first bonding member 4a in the Z-axis direction.

For instance, the positions of the fifth side surface 1se, the sixth side surface 1sf, the thirteenth side surface 1sm, and the fourteenth side surface 1sn of the second semiconductor chip 1b overlap the positions of the seventh side surface 4sg, the eighth side surface 4sh, the fifteenth side surface 4so, and the sixteenth side surface 4sp of the second bonding member 4b in the Z-axis direction, respectively. The four side surfaces of the second semiconductor chip 1b, i.e. the fifth side surface 1se, the sixth side surface 1sf, the thirteenth side surface 1sm, and the fourteenth side surface 1sn, are each located above the second bonding member 4b in the Z-axis direction.

Thus, the first length L1 is less than or equal to the second length L2 (L1 ≤ L2), and the fifth length L5 is less than or equal to the sixth length L6 (L5 ≤ L6). In this case, preferably, the first bonding member 4a is provided immediately below the first semiconductor chip 1a in the Z-axis direction from the viewpoint of e.g. heat dissipation. The third length L3 is less than or equal to the fourth length L4 (L3 ≤ L4), and the seventh length L7 is less than or equal to the eighth length L8 (L7 ≤ L8). In this case, preferably, the second bonding member 4b is provided immediately below the second semiconductor chip 1b in the Z-axis direction from the viewpoint of e.g. heat dissipation.

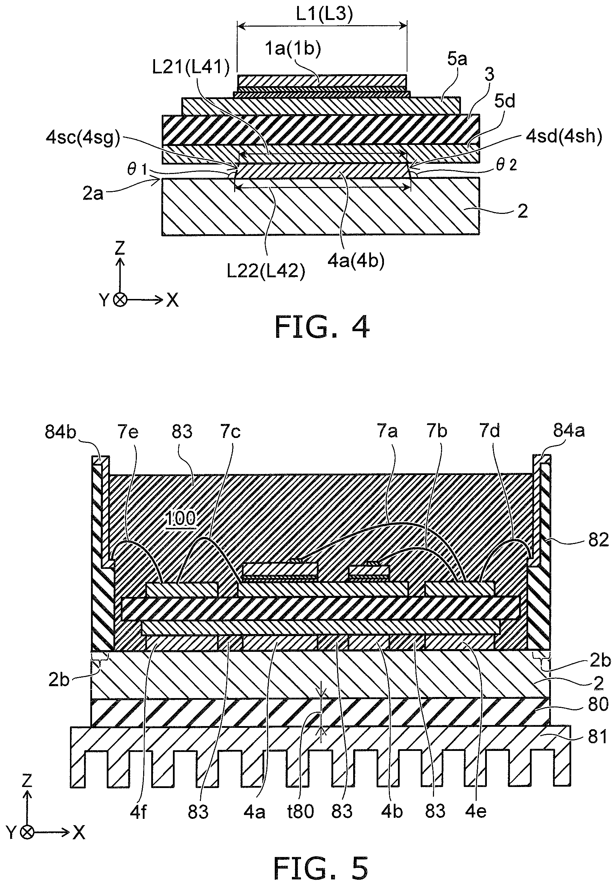

FIG. 4 is a schematic sectional view illustrating a semiconductor device according to the first example useful for understanding the invention.

As shown in FIG. 4, the angle θ1 is an angle formed by the upper surface 2a of the metal substrate 2 and the third side surface 4sc of the first bonding member 4a. The angle θ2 is an angle formed by the upper surface 2a of the metal substrate 2 and the fourth side surface 4sd of the first bonding member 4a. The angle θ1 and the angle θ2 may be unequal to e.g. the right angle. In the example shown in FIG. 4, θ1 > 90° and θ2 > 90°. The second length L21 in the X-axis direction at the top part of the first bonding member 4a is shorter than the second length L22 in the X-axis direction at the bottom part of the first bonding member 4a (L21 < L22).

The first bonding member 4a may include locations different in e.g. the second length L2 in a cross section taken along the X-axis direction and the Z-axis direction. In this case, the length of the location having the shortest length is adopted as the second length L2. In this example, the second length L21 at the top part of the first bonding member 4a is adopted as the second length L2. Then, e.g. the first length L1 can be made less than or equal to the second length L2 (L1 ≤ L2) wherever the second length L2 of the first bonding member 4a is measured.

The selection of the location for measuring the length also applies to the second bonding member 4b. The fourth length L41 in the X-axis direction at the top part of the second bonding member 4b may be shorter than the fourth length L42 in the X-axis direction at the bottom part of the second bonding member 4b (L41 < L42). In this case, the fourth length L41 at the top part of the second bonding member 4b is adopted as the fourth length L4. Although not shown particularly, the location for measuring the length can be selected as described above also in a cross section taken along the Y-axis direction and the Z-axis direction.

In the first example, the first bonding member 4a and the second bonding member 4b are made of e.g. a sintering bonding material.

The sintering bonding material contains metal fine particles, e.g. metal nanoparticles. The metal of the metal nanoparticle contains at least one selected from the group consisting of Ag (silver), Ni (nickel), and Cu (copper). Before sintering, the sintering bonding material is a paste in which e.g. metal nanoparticles having a surface protective film containing organic matter are dispersed in e.g. an organic solvent. For instance, a paste-like sintering bonding material enables the first bonding member 4a and the second bonding member 4b to be patterned in patterns spaced from each other in the X-axis direction before sintering. In this specification, sintering means e.g. forming a bonding state between metal nanoparticles adjacent at part of the surfaces without melting in the bulk portion by heating to a temperature lower than the melting point of the material.

The surface protective film of the metal nanoparticles and the organic solvent are removed by heating. The metal nanoparticles are in contact with each other. Sintering the metal nanoparticles in contact with each other results in forming the first bonding member 4a and the second bonding member 4b. Thus, the metal substrate 2 is bonded to the insulating substrate 3. During sintering, the first bonding member 4a and the second bonding member 4b are less prone to fluidization than a melting bonding material such as a solder material.

After sintering, the first bonding member 4a and the second bonding member 4b contain pores such as micropores. In the first example useful for understanding the invention, the first bonding member 4a and the second bonding member 4b are porous. The denseness of the porous first bonding member 4a is e.g. 60% or more and 95% or less. Likewise, the denseness of the porous second bonding member 4b is e.g. 60% or more and 95% or less. In this specification, a denseness of 100% represents the state with no pores. For a lower denseness, the proportion of pores occupied in the first bonding member 4a and the proportion of pores occupied in the second bonding member 4b are larger. The value "100% - denseness (%)" corresponds to the proportion of pores occupied in each of these bonding members.

The semiconductor device 100 further includes a third bonding member 4c, a fourth bonding member 4d, a fifth bonding member 4e, a sixth bonding member 4f, a first conductor 5a, a second conductor 5b, a third conductor 5c, and a fourth conductor 5d.

The first conductor 5a is provided between the first semiconductor chip 1a and the insulating substrate 3 and between the second semiconductor chip 1b and the insulating substrate 3. The second conductor 5b is spaced from the first conductor 5a and the third conductor 5c in the X-axis direction. The third conductor 5c is spaced from the first conductor 5a and the second conductor 5b in the X-axis direction. The first to third conductors 5a-5c are e.g. circuit interconnects provided on the insulating substrate 3. The first to third conductors 5a-5c contain e.g. Cu.

The third bonding member 4c is provided between the first conductor 5a and the first semiconductor chip 1a. At least part of the third bonding member 4c is located between the first semiconductor chip 1a and the first conductor 5a in the Z-axis direction. The fourth bonding member 4d is provided between the first conductor 5a and the second semiconductor chip 1b. At least part of the fourth bonding member 4d is located between the second semiconductor chip 1b and the first conductor 5a in the Z-axis direction. The third bonding member 4c bonds the first conductor 5a to the first semiconductor chip 1a. The fourth bonding member 4d bonds the first conductor 5a to the second semiconductor chip 1b. In the first example useful for understanding the invention, the third bonding member 4c and the fourth bonding member 4d are made of e.g. a sintering bonding material. The third bonding member 4c and the fourth bonding member 4d are e.g. porous. The porous third bonding member 4c and the porous fourth bonding member 4d contain at least one selected from the group consisting of Ag, Ni, and Cu. In the first embodiment, the third bonding member 4c and the fourth bonding member 4d may be made of a melting bonding material such as a solder material. The solder material contains e.g. Sn (tin).

The fifth bonding member 4e is provided between the metal substrate 2 and the insulating substrate 3. At least part of the fifth bonding member 4e is located between the second conductor 5b and the metal substrate 2 in the Z-axis direction. The sixth bonding member 4f is provided between the metal substrate 2 and the insulating substrate 3. At least part of the sixth bonding member 4f is located between the third conductor 5c and the metal substrate 2 in the Z-axis direction. The fifth bonding member 4e and the sixth bonding member 4f bond the metal substrate 2 to the insulating substrate 3. In the first example useful for understanding the invention, the fifth bonding member 4e and the sixth bonding member 4f are made of e.g. a sintering bonding material. The fifth bonding member 4e and the sixth bonding member 4f are e.g. porous. The porous fifth bonding member 4e and the porous sixth bonding member 4f contain at least one selected from the group consisting of Ag, Ni, and Cu. The fifth bonding member 4e and the sixth bonding member 4f may be provided for each of the second conductor 5b and the third conductor 5c.

The first semiconductor chip 1a includes a first electrode 6a and a second electrode 6b. In the first embodiment, the first electrode 6a is spaced from the second electrode 6b in the Z-axis direction. The second semiconductor chip 1b includes a third electrode 6c and a fourth electrode 6d. In the first embodiment, the third electrode 6c is spaced from the fourth electrode 6d in the Z-axis direction.

The first conductor 5a is electrically connected to each of the first semiconductor chip 1a and the second semiconductor chip 1b. The first electrode 6a is electrically connected to the first conductor 5a through the third bonding member 4c. The second electrode 6b is electrically connected to the second conductor 5b through a first wiring 7a. The third electrode 6c is electrically connected to the first conductor 5a through the fourth bonding member 4d. The fourth electrode 6d is electrically connected to the second conductor 5b through a second wiring 7b. The first conductor 5a is electrically connected to the third conductor 5c through a third wiring 7c.

The fourth conductor 5d is provided between the insulating substrate 3 and the first bonding member 4a, between the insulating substrate 3 and the second bonding member 4b, between the insulating substrate 3 and the fifth bonding member 4e, and between the insulating substrate 3 and the sixth bonding member 4f. The fourth conductor 5d is a metal foil or a circuit interconnect provided on the back surface of the insulating substrate 3. The fourth conductor 5d contains e.g. Cu.

FIG. 5 is another schematic sectional view illustrating a semiconductor device according to the first example useful for understanding the invention. FIG. 5 shows the state in which the semiconductor device 100 shown in FIG. 1 is housed in a casing and a heat dissipation member is attached to the metal substrate 2.

The semiconductor device 100 in the state shown in FIG. 5 further includes an intermediate member 80, a heat dissipation member 81, a casing 82, and a resin 83. The metal substrate 2 is provided between the first bonding member 4a and the intermediate member 80, between the second bonding member 4b and the intermediate member 80, between the fifth bonding member 4e and the intermediate member 80, and between the sixth bonding member 4f and the intermediate member 80. The intermediate member 80 is provided between the metal substrate 2 and the heat dissipation member 81. The intermediate member 80 is e.g. a thermal interface material (TIM). TIM is a heat transfer member. TIM is e.g. a grease containing thermally conductive filler, or an elastomer containing thermally conductive filler. The heat dissipation member 81 is e.g. a heat sink.

The metal substrate 2 includes an edge region 2b. The edge region 2b lies along the edge of the metal substrate 2. The casing 82 is provided on the edge region 2b. The casing 82 is shaped like a frame. The frame-shaped casing 82 surrounds the semiconductor device 100 shown in FIG. 1. The casing 82 is provided with a main terminal. FIG. 5 shows a main terminal 84a and a main terminal 84b. The main terminal 84a is electrically connected to e.g. the second conductor 5b through a fourth wiring 7d. The main terminal 84b is electrically connected to e.g. the third conductor 5c through a fifth wiring 7e.

The resin 83 is provided in the casing 82. The resin 83 is insulative. The resin 83 seals and insulates the semiconductor device 100 from outside. In the first example useful for understanding the invention, in the casing 82, the resin 83 is further provided between the first bonding member 4a and the second bonding member 4b, between the first bonding member 4a and the sixth bonding member 4f, and between the second bonding member 4b and the fifth bonding member 4e. The resin 83 has flexibility. The resin 83 can be deformed in response to expansion and contraction of e.g. the first bonding member 4a, the second bonding member 4b, the fifth bonding member 4e, the sixth bonding member 4f, the metal substrate 2, and the insulating substrate 3. Between the metal substrate 2 and the insulating substrate 3, the resin 83 may be provided between the first bonding member 4a and the second bonding member 4b, between the first bonding member 4a and the sixth bonding member 4f, and between the second bonding member 4b and the fifth bonding member 4e. For instance, in the first example useful for understanding the invention, between the metal substrate 2 and the insulating substrate 3, the resin 83 is filled in each gap between the first bonding member 4a and the second bonding member 4b, between the first bonding member 4a and the sixth bonding member 4f, and between the second bonding member 4b and the fifth bonding member 4e.

In the semiconductor device 100 of the first example useful for understanding the invention, the bonding member for bonding the metal substrate 2 to the insulating substrate 3 includes at least the first bonding member 4a and the second bonding member 4b. For instance, in the semiconductor device 100, the bonding member includes the first bonding member 4a, the second bonding member 4b, the fifth bonding member 4e, and the sixth bonding member 4f. In the semiconductor device 100, between the metal substrate 2 and the insulating substrate 3, the bonding member can be divided into a plurality of bonding members, and each bonding member can be selectively provided at a necessary location.

In such a semiconductor device 100, the thermal resistance of the bonding member can be reduced relative to a semiconductor device in which a solder material is provided entirely between the metal substrate 2 and the insulating substrate 3 (e.g., entirely between the metal substrate 2 and the fourth conductor 5d). For instance, the sintering bonding material has higher thermal conductivity than the solder material. Thus, when the bonding area is equal, the thermal resistance is reduced relative to the case of using the solder material. In the sintering bonding material, e.g. the thickness in the Z-axis direction of the bonding member can be made thinner than in the solder material. The thermal resistance increases when bonding is changed from overall bonding to partial bonding. However, partial bonding by the sintering bonding material can decrease the thermal resistance relative to overall bonding by the solder material because of both the high thermal conductivity of the sintering bonding material and the possibility of thinning the thickness in the Z-axis direction of the bonding member. Thus, the first example useful for understanding the invention can improve heat dissipation of the semiconductor device 100. For instance, the packaging density of a power semiconductor module is increasing. The increase of packaging density makes heat dissipation difficult. The first example useful for understanding the invention capable of improving heat dissipation is effective in the power semiconductor module with increasing packaging density.

There is a mismatch between the linear expansion coefficient $\alpha2$ of the metal substrate 2 and the linear expansion coefficient $\alpha3$ of the insulating substrate 3. For instance, the linear expansion coefficient $\alpha2$ of the metal substrate 2 containing copper is approximately 17. For instance, the linear expansion coefficient $\alpha3$ of the insulating substrate 3 containing alumina is approximately not less than 3 and not more than 8.

For instance, in the semiconductor device in which the metal substrate 2 is bonded to the insulating substrate 3 with a bonding member in the entire surface, the deformation of the metal substrate 2 is larger than in the case of bonding with bonding members separated in a plurality of areas. Large deformation of the metal substrate 2 incurs e.g. pump-out of the intermediate member 80 shown in FIG. 4. The pump-out of the intermediate member 80 increases the thermal resistance between the metal substrate 2 and the heat dissipation member 81.

In the first example useful for understanding the invention, between the metal substrate 2 and the insulating substrate 3, each bonding member can be selectively provided at a necessary location. Thus, after assembly, e.g. the deformation of the metal substrate 2 can be made small. Small deformation of the metal substrate 2 enables thinning the thickness t80 in the Z-axis direction of the intermediate member 80.

In the first example useful for understanding the invention, at the time of operation in which the temperature is high, the semiconductor device 100 (e.g. the metal substrate 2 of the semiconductor device 100) is less prone to deformation than the semiconductor device in which one bonding member is provided entirely between the metal substrate 2 and the insulating substrate 3. This can suppress pump-out of the intermediate member 80. As a result of suppressing pump-out of the intermediate member 80, the thickness t80 in the Z-axis direction of the intermediate member 80 can be made thinner.

The first example useful for understanding the invention can also suppress the increase of the thermal resistance of the intermediate member 80 because e.g.

(a) pump-out of the intermediate member 80 can be suppressed, and
(b) the thickness t80 in the Z-axis direction of the intermediate member 80 can be made thin.

The first semiconductor chip 1a and the second semiconductor chip 1b each have a high temperature in the operating state. The metal substrate 2 and the insulating substrate 3 expand when the first semiconductor chip 1a and the second semiconductor chip 1b are turned from the non-operating state to the operating state. The metal substrate 2 and the insulating substrate 3 contract when the first semiconductor chip 1a and the second semiconductor chip 1b are turned from the operating state to the non-operating state. Deformation of the metal substrate 2 and the insulating substrate 3 generates a stress inside the bonding member. Temperature change of the bonding member itself also generates a stress inside the bonding member. When the bonding area of one bonding member and the metal substrate 2 and the bonding area of one bonding member and the insulating substrate 3 are large, the stress generated inside one bonding member is large.

In the first example useful for understanding the invention, the bonding member includes a plurality of bonding members, e.g. at least the first bonding member 4a and the second bonding member 4b. In the first example useful for understanding the invention, at least the bonding area of the first bonding member 4a and the metal substrate 2, the bonding area of the second bonding member 4b and the metal substrate 2, the bonding area of the first bonding member 4a and the insulating substrate 3, and the bonding area of the second bonding member 4b and the insulating substrate 3 can each be made small. Thus, the stress generated inside the first bonding member 4a and the second bonding member 4b can each be made small. The first example useful for understanding the invention can also improve the reliability of bonding between the metal substrate 2 and the insulating substrate 3.

In forming the bonding member from a melting bonding material, the thickness in the Z-axis direction is made thick in view of tilt in case of fluidization.

In the first example useful for understanding the invention, the bonding members, e.g. the first bonding member 4a, the second bonding member 4b, the fifth bonding member 4e, and the sixth bonding member 4f, are each a sintering bonding material. The sintering bonding material is less prone to fluidization than a melting bonding material such as a solder material at the time of bonding.

The bonding members, e.g. the first bonding member 4a, the second bonding member 4b, the fifth bonding member 4e, and the sixth bonding member 4f, are made of a sintering bonding material. In this case, compared with the bonding members made of a melting bonding material, the first thickness t1 in the Z-axis direction of the first bonding member 4a, the second thickness t2 in the Z-axis direction of the second bonding member 4b, the fifth thickness t5 in the Z-axis direction of the fifth bonding member 4e, and the sixth thickness t6 in the Z-axis direction of the sixth bonding member 4f can be made thinner.

For instance, the bonding member of the semiconductor device 100 may be made of a melting bonding material such as a solder material containing Sn. In this case, the thickness in the Z-axis direction required for the bonding member is approximately 310-350 $\mu$m.

In contrast, each bonding member of the semiconductor device 100 of the first example useful for understanding the invention is made of a sintering bonding material. In this case, the first thickness t1 in the Z-axis direction of the first bonding member 4a, the second thickness t2 in the Z-axis direction of the second bonding member 4b, the fifth thickness t5 in the Z-axis direction of the fifth bonding member 4e, and the sixth thickness t6 in the Z-axis direction of the sixth bonding member 4f can each be set to 50 $\mu$m or more and 200 $\mu$m or less.

According to the first example useful for understanding the invention, the thicknesses t1, t2, t5, and t6 in the Z-axis direction are set to 50 $\mu$m or more and 200 $\mu$m or less. This can further reduce the thermal resistance of the bonding members including the first bonding member 4a, the second bonding member 4b, the fifth bonding member 4e, and the sixth bonding member 4f.

The thermal conductivity of a melting bonding material such as a solder material containing Sn is approximately 50 W/(m·K).

In contrast, the bonding member of the semiconductor device 100 of the first embodiment is made of a sintering bonding material. In this case, the first thermal conductivity $\lambda$1 of the first bonding member 4a, the second thermal conductivity $\lambda$2 of the second bonding member 4b, the fifth thermal conductivity $\lambda$5 of the fifth bonding member 4e, and the sixth thermal conductivity $\lambda$6 of the sixth bonding member 4f can each be set to e.g. 80 W/(m·K) or more and 350 W/(m·K) or less.

According to the first example useful for understanding the invention, the thermal conductivity $\lambda$1, $\lambda$2, $\lambda$5, and $\lambda$6 are each set to e.g. 80 W/(m·K) or more and 350 W/(m·K) or less. This can further reduce the thermal resistance of the bonding members including the first bonding member 4a, the second bonding member 4b, the fifth bonding member 4e, and the sixth bonding member 4f.

(Second example useful for understanding the invention)

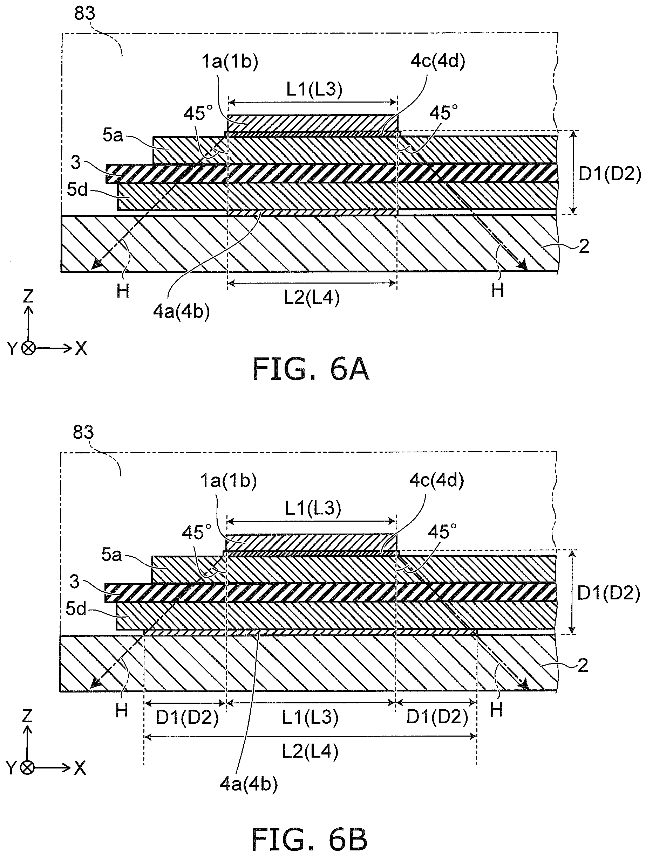

FIGS. 6A and 6B are schematic sectional views illustrating a semiconductor device according to a second example useful for understanding the invention. FIGS. 6A and 6B show the case of the first semiconductor chip 1a. The relationship shown in FIGS. 6A and 6B similarly holds also in the case of the second semiconductor chip 1b. The parenthesized reference numerals in FIGS. 6A and 6B represent the case of being replaced by the second semiconductor chip 1b.

As shown in FIG. 6A and 6B, the heat H generated by the first semiconductor chip 1a spreads outward at an angle of e.g. approximately 45° from the Z-axis direction toward the insulating substrate 3 and the metal substrate 2. Determination of the size of the first bonding member 4a and the second bonding member 4b preferably takes into account e.g. the "spread of heat H" shown in FIG. 6A and 6B.

FIG. 6A shows the case where the second length L2 of the first bonding member 4a is equal to the first length L1 of the first semiconductor chip 1a (L1 = L2). As shown by the parenthesized reference numerals, FIG. 6A shows the case where the fourth length L4 of the second bonding member 4b is equal to the third length L3 of the second semiconductor chip 1b (L3 = L4).

In the second example useful for understanding the invention, the state shown in FIG. 6A corresponds to e.g. the minimum of the second length L2 of the first bonding member 4a and the minimum of the fourth length L4 of the second bonding member 4b.

FIG. 6B shows the case where the second length L2 of the first bonding member 4a is longer than the first length L1 of the first semiconductor chip 1a (L1 < L2). FIG. 6A shows the case where the fourth length L4 of the second bonding member 4b is longer than the third length L3 of the second semiconductor chip 1b (L3 < L4).

From the first semiconductor chip 1a or the second semiconductor chip 1b, the heat H spreads outward at an angle of e.g. approximately 45° from the Z-axis direction toward the metal substrate 2. In the state shown in FIG. 6B, the second length L2 or the fourth length L4 is substantially equal to the width of the heat H first received by the metal substrate 2.

In the second example useful for understanding the invention, the state shown in FIG. 6B corresponds to e.g. the maximum of the second length L2 of the first bonding member 4a and the maximum of the fourth length L4 of the second bonding member 4b.

In the second example useful for understanding the invention, e.g. the first length L1 of the first semiconductor chip 1a, the second length L2 of the first bonding member 4a, and the first distance D1 from the first semiconductor chip 1a to the metal substrate 2 in the Z-axis direction satisfy the following relation.

$$L1 \leq L2 \leq L1 + (D1 \times 2) \qquad (1)$$

When the first length L1 is taken along a diagonal, the second length L2 is equal to a maximum second length L2max. In this case, the maximum second length L2max, the first length L1, and the first distance D1 satisfy the following relation.

$$L2max \leq L1 + \{(2\sqrt{3}) \times D1\} \qquad (1a)$$

In the second example useful for understanding the invention, e.g. the third length L3 of the second semiconductor chip 1b, the fourth length L4 of the second bonding member 4b, and the second distance D2 from the second semiconductor chip 1b to the metal substrate 2 in the Z-axis direction satisfy the following relation.

$$L3 \leq L4 \leq L3 + (D2 \times 2) \qquad (2)$$

When the third length L3 is taken along a diagonal, the maximum fourth length L4max, the third length L3, and the second distance D2 satisfy the following relation.

$$L4max \leq L3 + \{(2\sqrt{3}) \times D2\} \qquad (2a)$$

According to the second example useful for understanding the invention, the second length L2 of the first bonding member 4a and the fourth length L4 of the second bonding member 4b are set within the range satisfying relations (1) and (2). This can reduce the thermal stress of each of the first bonding member 4a and the second bonding member 4b while ensuring heat dissipation from the first semiconductor chip 1a and the second semiconductor chip 1b.

A similar relation holds also in the Y-axis direction. More specifically, in the second example useful for understanding the invention, e.g. the fifth length L5 of the first semiconductor chip 1a, the sixth length L6 of the first bonding member 4a, and the first distance D1 from the first semiconductor chip 1a to the metal substrate 2 in the Z-axis direction satisfy the following relation.

$$L5 \leq L6 \leq L5 + (D1 \times 2) \qquad (3)$$

When the fifth length L5 is taken along a diagonal, the maximum sixth length L6max, the fifth length L5, and the first distance D1 satisfy the following relation.

$$L6max \leq L5 + \{(2\sqrt{3}) \times D1\} \qquad (3a)$$

Likewise, e.g. the seventh length L7 of the second semiconductor chip 1b, the eighth length L8 of the second bonding member 4b, and the second distance D2 from the second semiconductor chip 1b to the metal substrate 2 in the Z-axis direction satisfy the following relation.

$$L7 \leq L8 \leq L7 + (D2 \times 2) \qquad (4)$$

When the seventh length L7 is taken along a diagonal, the maximum eighth length L8max, the seventh length L7, and the second distance D2 satisfy the following relation.

$$L8max \leq L7 + \{(2\sqrt{3}) \times D2\} \qquad (4a)$$

(Third example useful for understanding the invention)

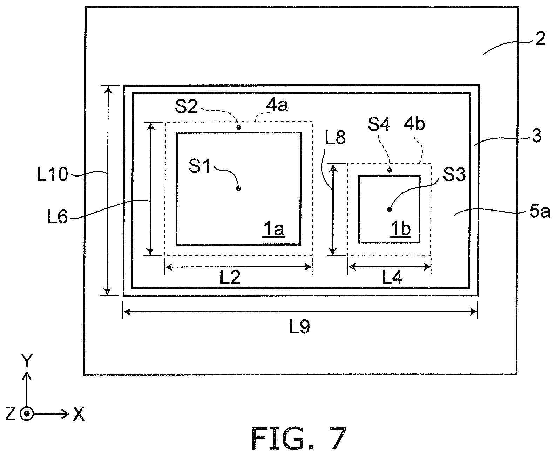

FIG. 7 is a schematic plan view illustrating a semiconductor device according to a third example useful for understanding the invention.

As shown in FIG. 7, the size of the bonding member, e.g. the first bonding member 4a, may take into account the first area S1 of the first semiconductor chip 1a and the second area S2 of the first bonding member 4a. The size of the second bonding member 4b may take into account the third area S3 of the second semiconductor chip 1b and the fourth area S4 of the second bonding member 4b.

In the third example useful for understanding the invention, the first area S1 of the first semiconductor chip 1a and the second area S2 of the first bonding member 4a satisfy the following relation.

$$1.0 \leq S2/S1 \leq 3.0 \qquad (5)$$

The first area S1 is the area of the first semiconductor chip 1a in the intersection plane crossing the Z-axis direction (S1 = L1×L5). The intersection plane is e.g. an XY plane taken along the X-axis direction and the Y-axis direction. The second area S2 is the area of the first bonding member 4a in the intersection plane (S2 = L2×L6).

In the third embodiment, the third area S3 of the second semiconductor chip 1b and the fourth area S4 of the second bonding member 4b satisfy the following relation.

$$1.0 \leq S4/S3 \leq 3.0 \qquad (6)$$

The third area S3 is the area of the second semiconductor chip 1b in the intersection plane (S3 = L3×L7). The fourth area S4 is the area of the second bonding member 4b in the intersection plane (S4 = L4×L8).

In the third example useful for understanding the invention, the state of S2=S1 or the state of S4=S3 corresponds to the minimum of the second area S2 of the first bonding member 4a or the minimum of the fourth area S4 of the second bonding member 4b. This is based on the fact that heat is likely to stagnate in the first bonding member 4a and the second bonding member 4b when e.g. the second area S2 of the first bonding member 4a is smaller than the first area of the first semiconductor chip 1a (S2/S1 < 1.0) and the fourth area S4 of the second bonding member 4b is smaller than the third area S3 of the second semiconductor chip 1b (S4/S3 < 1.0). The maximum of the second area S2 of the first bonding member 4a and the maximum of the fourth area S4 of the second bonding member 4b correspond to e.g. S2/S1 = 3.0 or S4/S3 = 3.0. This is because heat dissipation improves up to e.g. approximately S2/S1 = 3.0 or S4/S3 = 3.0.

In the third example useful for understanding the invention, e.g. the ninth length L9 of the insulating substrate 3 in the X-axis direction, the second length L2 of the first bonding member 4a, and the fourth length L4 of the second bonding member 4b satisfy the following relation.

$$L9 > L2 + L4 \qquad (7)$$

Likewise, e.g. the tenth length L10 of the insulating substrate 3 in the Y-axis direction and the sixth length L6 of the first bonding member 4a satisfy the following relation.

$$L10 > L6 \qquad (8)$$

Likewise, e.g. the tenth length L10 of the insulating substrate 3 in the Y-axis direction and the eighth length L8 of the second bonding member 4b satisfy the following relation.

$$L10 > L8 \qquad (9)$$

According to the third example useful for understanding the invention, the first area S1 of the first semiconductor chip 1a, the second area S2 of the first bonding member 4a, the third area S3 of the second semiconductor chip 1b, and the fourth area S4 of the second bonding member 4b are set within the range satisfying relations (5) and (6). This can reduce e.g. the thermal resistance of each of the first bonding member 4a and the second bonding member 4b while suppressing the decrease of bonding strength between the metal substrate 2 and the insulating substrate 3.

(Fourth example useful for understanding the invention)

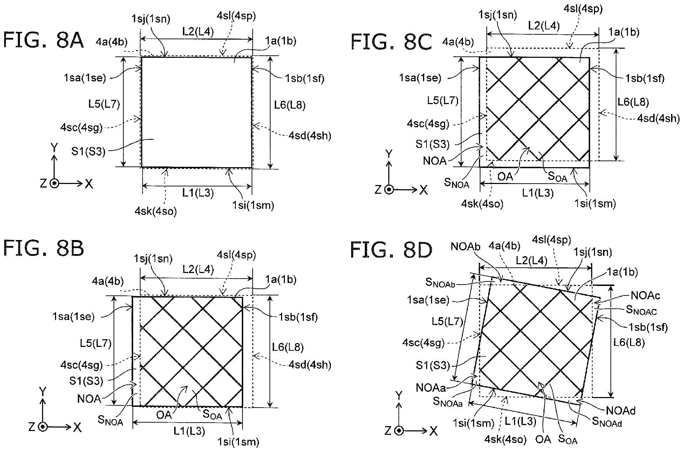

FIGS. 8A to 8D are schematic plan views illustrating a semiconductor device according to a fourth example useful for understanding the invention. The semiconductor device shown in FIGS. 8A to 8D satisfies e.g. L1 ≤ L2, L3 ≤ L4, L5 ≤ L6, and L7 ≤ L8.

As shown in FIGS. 8A to 8D, e.g. in the power semiconductor module, as viewed in the XY plane, the first semiconductor chip 1a may be misaligned from the first bonding member 4a. Alternatively, the second semiconductor chip 1b may be misaligned from the second bonding member 4b. On the other hand, the first semiconductor chip 1a may be intentionally displaced from the first bonding member 4a. Alternatively, the second semiconductor chip 1b may be intentionally displaced from the second bonding member 4b.

FIG. 8A shows the state in which the first semiconductor chip 1a and the first bonding member 4a are e.g. exactly aligned. Alternatively, FIG. 8A shows the state in which the second semiconductor chip 1b and the second bonding member 4b are e.g. exactly aligned.

In this case, the four side surfaces of the first semiconductor chip 1a, i.e. the first side surface 1sa, the second side surface 1sb, the ninth side surface 1si, and the tenth side surface 1sj, are each located above the first bonding member 4a in the Z-axis direction. Alternatively, the four side surfaces of the second semiconductor chip 1b, i.e. the fifth side surface 1se, the sixth side surface 1sf, the thirteenth side surface 1sm, and the fourteenth side surface 1sn, are each located above the second bonding member 4b in the Z-axis direction.

FIG. 8B shows the state of the first semiconductor chip 1a misaligned in the X-axis direction, or the state of the second semiconductor chip 1b misaligned in the X-axis direction.

In this case, the position of the second side surface 1sb of the first semiconductor chip 1a in the X-axis direction and the position of the third side surface 4sc of the first bonding member 4a in the X-axis direction are located between the position of the first side surface 1sa of the first semiconductor chip 1a and the position of the fourth side surface 4sd of the first bonding member 4a. Among the four side surfaces of the first semiconductor chip 1a, three side surfaces are located above the first bonding member 4a in the Z-axis direction. For instance, three side surfaces of the first semiconductor chip 1a, i.e. the second side surface 1sb, the ninth side surface 1si, and the tenth side surface 1sj, are located above the first bonding member 4a in the Z-axis direction.

Alternatively, the position of the sixth side surface 1sf of the second semiconductor chip 1b in the X-axis direction and the position of the seventh side surface 4sg of the second bonding member 4b in the X-axis direction are located between the position of the fifth side surface 1se of the second semiconductor chip 1b and the position of the eighth side surface 4sh of the second bonding member 4b. Among the four side surfaces of the second semiconductor chip 1b, three side surfaces are located above the second bonding member 4b in the Z-axis direction. For instance, three side surfaces of the second semiconductor chip 1b, i.e. the sixth side surface 1sf, the thirteenth side surface 1sm, and the fourteenth side surface 1sn, are located above the second bonding member 4b in the Z-axis direction.

In this case, the first semiconductor chip 1a or the second semiconductor chip 1b has a non-overlapping region NOA. The non-overlapping region NOA is a region in which the first semiconductor chip 1a does not overlap the first bonding member 4a or the second semiconductor chip 1b does not overlap the second bonding member 4b in the Z-axis direction.

Even when the first semiconductor chip 1a or the second semiconductor chip 1b includes a non-overlapping region NOA, there are cases where the non-overlapping region NOA is allowable. For instance, the first semiconductor chip 1a or the second semiconductor chip 1b includes an overlapping region OA. The overlapping region OA is a region in which the first semiconductor chip 1a overlaps the first bonding member 4a or the second semiconductor chip 1b overlaps the second bonding member 4b in the Z-axis direction. The non-overlapping region NOA is allowable when the area $S_{OA}$ of the overlapping region OA is e.g. 90% or more of the first area S1 of the first semiconductor chip 1a. The area $S_{OA}$ is the area of the overlapping region OA in the XY plane. Alternatively, the non-overlapping region NOA is allowable when the area $S_{OA}$ of the overlapping region OA is e.g. 90% or more of the third area S3 of the second semiconductor chip 1b. In this specification, a first allowable area is defined as the area $S_{OA}$ equal to e.g. 90% of the first area S1 or the third area S3. The first allowable area can be determined in consideration of e.g. at least one of heat dissipation and bonding strength.

Whether the non-overlapping region NOA is allowable may be determined based on the area $S_{NOA}$ of the non-overlapping region NOA. The area $S_{NOA}$ is the area of the non-overlapping region NOA in the XY plane. The non-overlapping region NOA is allowable when the area $S_{NOA}$ is e.g. less than 10% of the first area S1. Alternatively, the non-overlapping region NOA is allowable when the area $S_{NOA}$ is e.g. less than 10% of the third area S3. In this specification, a second allowable area is defined as the area $S_{NOA}$ equal to e.g. 10% of the first area S1 or the third area S3. The second allowable area can also be determined in consideration of e.g. at least one of heat dissipation and bonding strength.

Thus, there may be a non-overlapping region NOA between the first semiconductor chip 1a and the first bonding member 4a or between the second semiconductor chip 1b and the second bonding member 4b if e.g. the area $S_{OA}$ of the overlapping region OA is more than or equal to the first allowable area. Alternatively, there may be a non-overlapping region NOA if the area $S_{NOA}$ of the non-overlapping region NOA is less than the second allowable area.

FIG. 8C shows the state of the first semiconductor chip 1a misaligned in both the X-axis direction and the Y-axis direction, or the state of the second semiconductor chip 1b misaligned in both the X-axis direction and the Y-axis direction.

In this case, among the four side surfaces of the first semiconductor chip 1a, two side surfaces are located above the first bonding member 4a in the Z-axis direction. In this example, two side surfaces, e.g. the second side surface 1sb and the tenth side surface 1sj adjacent to the second side surface 1sb are located above the first bonding member 4a. Alternatively, among the four side surfaces of the second semiconductor chip 1b, two side surfaces are located above the second bonding member 4b in the Z-axis direction. In this example, two side surfaces, e.g. the sixth side surface 1sf and the fourteenth side surface 1sn adjacent to the sixth side surface 1sf are located above the second bonding member 4b.

The first semiconductor chip 1a or the second semiconductor chip 1b may be misaligned in both the X-axis direction and the Y-axis direction if e.g. the area $S_{OA}$ is more than or equal to the first allowable area. Alternatively, the first semiconductor chip 1a or the second semiconductor chip 1b may be misaligned in both the X-axis direction and the Y-axis direction if the area $S_{NOA}$ is less than the second allowable area.

FIG. 8D shows the state of the first semiconductor chip 1a rotated about the Z-axis, or the state of the second semiconductor chip 1b rotated about the Z-axis.

In this case, the four side surfaces of the first semiconductor chip 1a are located above the first bonding member 4a in the Z-axis direction. However, the first semiconductor chip 1a or the second semiconductor chip 1b includes non-overlapping regions NOA such as first to fourth non-overlapping regions NOA1-NOA4.

The first semiconductor chip 1a or the second semiconductor chip 1b may be rotated about the Z-axis if e.g. the area $S_{OA}$ is more than or equal to the first allowable area. The first semiconductor chip 1a or the second semiconductor chip 1b may include a plurality of non-overlapping regions NOA.

When the first semiconductor chip 1a or the second semiconductor chip 1b includes a plurality of non-overlapping regions NOA, e.g. the area $S_{NOA}$ can be defined as the total value of the areas $S_{NOA}$ of the plurality of non-overlapping regions NOA. In this example, e.g. the area $S_{NOA}$ is defined as the total area of the areas $S_{NOAa}$-$S_{NOAd}$ ($S_{NOAa}$ + $S_{NOAb}$ + $S_{NOAc}$ + $S_{NOAd}$). The area $S_{NOAa}$ is the area of the first non-overlapping region NOA1 in the XY plane. The area $S_{NOAb}$ is the area of the second non-overlapping region NOA2 in the XY plane. The area $S_{NOAc}$ is the area of the third non-overlapping region NOA3 in the XY plane. The area $S_{NOAd}$ is the area of the fourth non-overlapping region NOA4 in the XY plane. The first semiconductor chip 1a or the second semiconductor chip 1b may include a plurality of non-overlapping regions NOA if the total area $S_{NOA}$ of the respective areas is less than the second allowable area.

(Fifth example useful for understanding the invention)

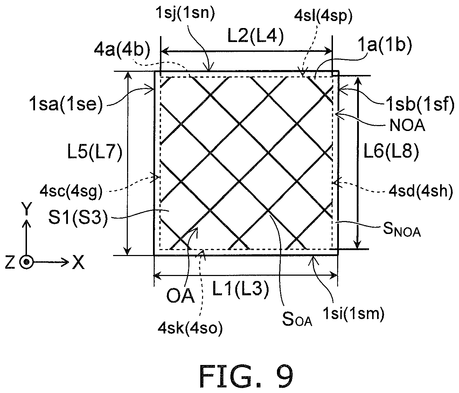

FIG. 9 is a schematic plan view illustrating a semiconductor device according to a fifth example useful for understanding the invention.

The fourth example useful for understanding the invention has described that there are cases where the non-overlapping region NOA is allowable. From this viewpoint, e.g. as shown in FIG. 9, e.g. the first length L1 can be made longer than the second length L2, and the fifth length L5 can be made longer than the sixth length L6 (L1 > L2, L5 > L6) if e.g. the area $S_{OA}$ is more than or equal to the first allowable area, or the area $S_{NOA}$ is less than the second allowable area. Alternatively, e.g. the third length L3 can be made longer than the fourth length L4, and the seventh length L7 can be made longer than the eighth length L8 (L3 > L4, L7 > L8).

(Invention)

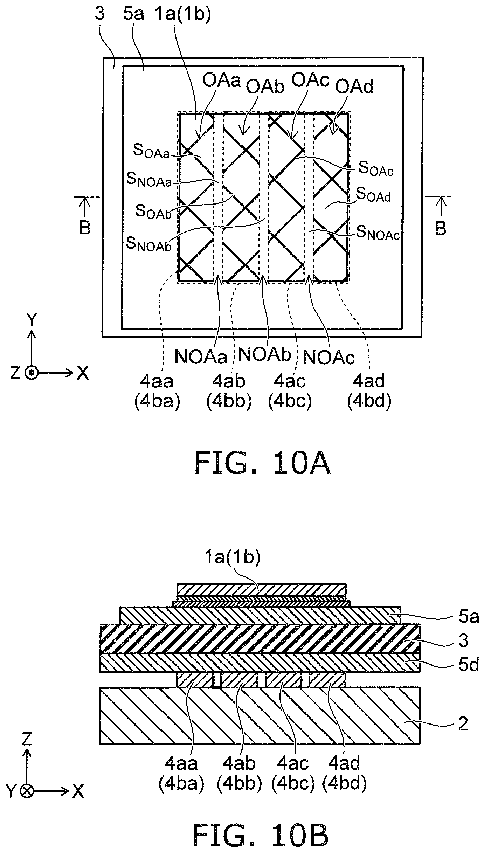

FIG. 10A is a schematic plan view illustrating a semiconductor device according to an example useful for understanding the invention. FIG. 10B is a schematic sectional view taken along line B-B in FIG. 10A.

As shown in FIGS. 10A and 10B, at least one of the first bonding member 4a and the second bonding member 4b are divided into a plurality of bonding pieces if e.g. the area $S_{OA}$ of the overlapping region OA is more than or equal to the first allowable area or the area $S_{NOA}$ of the non-overlapping region NOA is less than the second allowable area. In this embodiment, the first bonding member 4a includes e.g. four bonding pieces, i.e. first to fourth bonding pieces 4aa-4ad. Alternatively, the second bonding member 4b includes e.g. four bonding pieces, i.e. fifth to eighth bonding pieces 4ba-4bd. The number of bonding pieces is not limited to four. The number of bonding pieces can be set arbitrarily.

In the Z-axis direction, as the overlapping region OA, the first semiconductor chip 1a includes first to fourth overlapping regions OAa-OAd with the first to fourth bonding pieces 4aa-4ad, respectively. For instance, in the X-axis direction, the first to fourth bonding pieces 4aa-4ad are spaced from each other. The region between the first bonding piece 4aa and the second bonding piece 4ab adjacent to the first bonding piece 4aa in the X-axis direction is a first non-overlapping region NOAa. The region between the second bonding piece 4ab and the third bonding piece 4ac adjacent to the second bonding piece 4ab in the X-axis direction is a second non-overlapping region NOAb. The region between the third bonding piece 4ac and the fourth bonding piece 4ad adjacent to the third bonding piece 4ac in the X-axis direction is a third non-overlapping region NOAc.

In the Z-axis direction, as the overlapping region OA, the second semiconductor chip 1b includes first to fourth overlapping regions OAa-OAd with the fifth to eighth bonding pieces 4ba-4bd, respectively. For instance, in the X-axis direction, the fifth to eighth bonding pieces 4ba-4bd are spaced from each other. The region between the fifth bonding piece 4ba and the sixth bonding piece 4bb adjacent to the fifth bonding piece 4ba in the X-axis direction is a first non-overlapping region NOAa. The region between the sixth bonding piece 4bb and the seventh bonding piece 4bc adjacent to the sixth bonding piece 4bb in the X-axis direction is a second non-overlapping region NOAb. The region between the seventh bonding piece 4bc and the eighth bonding piece 4bd adjacent to the seventh bonding piece 4bc in the X-axis direction is a third non-overlapping region NOAc.

According to the invention, the first bonding member 4a or the second bonding member 4b can include a plurality of bonding pieces if e.g. the total area of the areas $S_{OAa}$-$S_{OAd}$ of the first to fourth overlapping regions OAa-OAd ($S_{OAa} + S_{OAb} + S_{OAc} + S_{OAd}$) is more than or equal to the first allowable area. Alternatively, the first bonding member 4a or the second bonding member 4b can include a plurality of bonding pieces if the total area of the areas $S_{NOAa}$-$S_{NOAc}$ of the first to third non-overlapping regions NOAa-NOAc ($S_{NOAa} + S_{NOAb} + S_{NOAc}$) is less than the second allowable area.

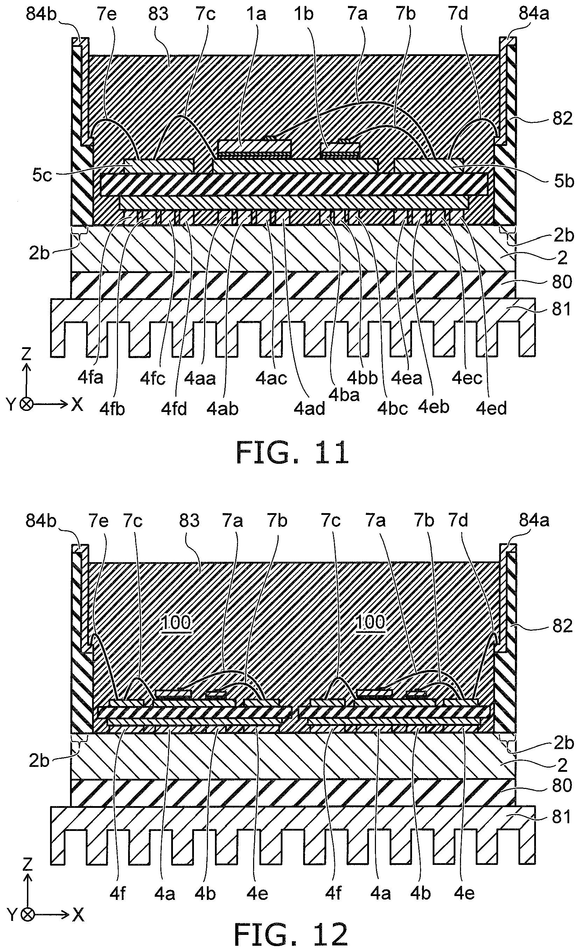

FIG. 11 is another schematic sectional view illustrating a semiconductor device according to the invention. FIG. 11 shows the state in which the semiconductor device shown in FIGS. 10A and 10B is housed in a casing and a heat dissipation member is attached to the metal substrate 2.

In the example shown in FIG. 11, the fifth bonding member 4e or the sixth bonding member 4f is divided into a plurality of bonding pieces. In this embodiment, the fifth bonding member 4e includes e.g. four bonding pieces, i.e. ninth to twelfth bonding pieces 4ea-4ed. The sixth bonding member 4f includes e.g. four bonding pieces, i.e. thirteenth to sixteenth bonding pieces 4fa-4fd. The number of bonding pieces is not limited to four. The number of bonding pieces can be set arbitrarily.

The semiconductor device according to the invention is sealed and insulated with the resin 83 in the casing 82. In this case, the region between the bonding pieces is filled with e.g. the resin 83.

The first bonding member 4a, the second bonding member 4b, the fifth bonding member 4e, and the sixth bonding member 4f are not limited to be respectively single as in the sixth embodiment. The first bonding member 4a, the second bonding member 4b, the fifth bonding member 4e, and the sixth bonding member 4f may be provided in a plurality for each. Part of at least one bonding piece of the first to fourth bonding pieces 4aa-4ad is located between the first semiconductor chip 1a and the metal substrate 2 in the Z-axis direction. Part of at least one bonding piece of the fifth to eighth bonding pieces 4ba-4bd is located between the second semiconductor chip 1b and the metal substrate 2 in the Z-axis direction. Part of at least one bonding piece of the ninth to twelfth bonding pieces 4ea-4ed is located between the second conductor 5b and the metal substrate 2 in the Z-axis direction. Part of at least one bonding piece of the thirteenth to sixteenth bonding pieces 4fa-4fd is located between the third conductor 5c and the metal substrate 2 in the Z-axis direction. Although not shown, at least one of the first bonding member 4a, the second bonding member 4b, the fifth bonding member 4e, and the sixth bonding member 4f can be provided in a plurality, and the rest can be single. The embodiment of the invention can be combined with the second to fifth examples useful for understanding the invention.

(Seventh embodiment)

FIG. 12 is a schematic sectional view illustrating a semiconductor device according to a seventh example useful for understanding the invention.

As shown in FIG. 12, the seventh example useful for understanding the invention is different from e.g. the first example useful for understanding the invention in that e.g. a plurality of semiconductor devices 100 are housed in one casing 82.

As in the seventh example useful for understanding the invention, a plurality of semiconductor devices 100 can be housed in one casing 82. The amount of heat generation of the semiconductor device 100 is larger in the case of housing a plurality of semiconductor devices 100 than in the case of housing one semiconductor device 100. For instance, a power semiconductor module with a plurality of semiconductor devices 100 housed in one casing 82 is more prone to deformation. The first to fourth examples useful for understanding the invention can be applied more effectively to e.g. a power semiconductor module with a plurality of semiconductor devices 100 housed in one casing 82 as in the seventh example useful for understanding the invention. The seventh example useful for understanding the invention can be combined with the second to sixth example useful for understanding the invention.

As described above, the examples useful for understanding the invention as well as the invention itself can provide a semiconductor device capable of improving heat dissipation.

**Claims**

1. A semiconductor device (100) comprising:

   a first semiconductor chip (1a);
   a second semiconductor chip (1b);
   a metal substrate (2) spaced from the first semiconductor chip and the second semiconductor chip in a first, Z, direction crossing a second, X, direction from the first semiconductor chip to the second semiconductor chip, wherein the second, X, direction is orthogonal to the first direction and to a third, Y, direction;
   an insulating substrate (3) provided between the first semiconductor chip and the metal substrate and between the second semiconductor chip and the metal substrate;
   a first bonding member (4a) provided between the metal substrate and the insulating substrate, at least part of the first bonding member being located between the first semiconductor chip and the metal substrate in the first direction; and
   a second bonding member (4b) provided between the metal substrate and the insulating substrate, at least part of the second bonding member being located between the second semiconductor chip and the metal substrate in the first direction wherein
   the first semiconductor chip includes a first overlapping region (OAa) overlapping the first bonding member in the first direction, and an area of the first overlapping region in an intersection plane in the XY plane crossing the first direction is 90 percent or more of a first area of the first semiconductor chip in the intersection plane, wherein
   the first bonding member includes a first bonding piece (4aa) and a second bonding piece (4ab) **characterized by** a resin (83) provided between the first bonding piece and the second bonding piece in the second, X, direction.

2. The device according to claim 1, wherein a first length (L1) of the first semiconductor chip along the second, X, direction perpendicular to the first direction (Z) is less than or equal to a second length (L2) of the first bonding member along the second direction.

3. The device according to claim 1 or 2, wherein the first bonding member and the second bonding member are porous at a denseness of 60 percent or more and 95 percent or less.

4. The device according to any one of claims 1-3, wherein
   a first thickness (t1) along the first direction of the first bonding member is 50 $\mu$m or more and 200 $\mu$m or less, and
   a second thickness (t2) along the first direction of the second bonding member is 50 $\mu$m or more and 200 $\mu$m or less.

5. The device according to any one of claims 1-4, wherein
   a first thermal conductivity of the first bonding member is 80 W/(m·K) or more and 350 W/(m·K) or less, and
   a second thermal conductivity of the second bonding member is 80 W/(m·K) or more and 350 W/(m·K) or less.

6. The device according to any one of claims 1-5, wherein a first area S1 of the first semiconductor chip in an intersection plane crossing the first direction and a second area S2 of the first bonding member in the intersection plane satisfy a relation of

$$1.0 \le S2/S1 \le 3.0.$$

7. The device according to claim 6, wherein a third area S3 in the intersection plane of the second semiconductor chip and a fourth area S4 in the intersection plane of the second bonding member satisfy a relation of

$$1.0 \le S4/S3 \le 3.0.$$

8. The device according to any one of claims 1-7, further comprising:

   an intermediate member (80); and
   a heat dissipation member (81),
   wherein the metal substrate is provided between the first bonding member and the intermediate member and between the second bonding member and the intermediate member, and

the intermediate member is provided between the metal substrate and the heat dissipation member.

9.  The device according to any one of claims 1-8, further comprising:

    a resin (83) provided between the first bonding member and the second bonding member in a second, x, direction crossing the first, Z, direction.

10. The device according to claim 1, wherein a first length (L1) of the first semiconductor chip along the second direction perpendicular to the first direction is longer than a second length (L2) of the first bonding member along the one direction.

11. The device according to claim 2, wherein the first length L1, the second length L2, and a first distance D1 from the first semiconductor chip to the metal substrate in the first direction satisfy a relation of

$$L2 \leq L1 + (D1 \times 2).$$

12. The device according to claim 2, wherein a third length (L3) along the second direction of the second semiconductor chip is less than or equal to a fourth length (L4) along the one direction of the second bonding member.

13. The device according to claim 12, wherein the third length L3, the fourth length L4, and a second distance D2 from the second semiconductor chip to the metal substrate in the first direction satisfy a relation of

$$L4 \leq L3 + (D2 \times 2).$$

14. The device according to claim 2, wherein a fifth length L5 of the first semiconductor chip along an intersection direction being perpendicular to the first direction and crossing the second direction is less than or equal to a sixth length (L6) of the first bonding member along the intersection direction.

15. The device according to claim 14, wherein the fifth length L5, the sixth length L6, and a first distance D1 from the first semiconductor chip to the metal substrate in the first direction satisfy a relation of

$$L6 \leq L5 + (D1 \times 2).$$

16. The device according to claim 14, wherein a seventh length L7 along the intersection direction of the second semiconductor chip is less than or equal to an eighth length along the intersection direction of the second bonding member.

17. The device according to claim 16, wherein the seventh length L7, the eighth length L8, and a second distance D2 from the second semiconductor chip to the metal substrate in the first direction satisfy a relation of

$$L7 \leq L8 \leq L7 + (D2 \times 2).$$

**Patentansprüche**

1.  Halbleitervorrichtung (100), umfassend:

    einen ersten Halbleiterchip (1a);
    einen zweiten Halbleiterchip (1b);
    ein Metallsubstrat (2), welches von dem ersten Halbleiterchip und dem zweiten Halbleiterchip in einer ersten, Z-, Richtung, welche eine zweite, X-, Richtung von dem ersten Halbleiterchip zu dem zweiten Halbleiterchip kreuzt, beabstandet ist, wobei die zweite, X-, Richtung orthogonal zu der ersten Richtung und zu einer dritten, Y-, Richtung ist;
    ein isolierendes Substrat (3), welches zwischen dem ersten Halbleiterchip und dem Metallsubstrat und zwischen dem zweiten Halbleiterchip und dem Metallsubstrat bereitgestellt ist;

ein erstes Verbindungselement (4a), welches zwischen dem Metallsubstrat und dem isolierenden Substrat bereitgestellt ist, wobei zumindest ein Teil des ersten Verbindungselements sich zwischen dem ersten Halbleiterchip und dem Metallsubstrat in der ersten Richtung befindet; und

ein zweites Verbindungselement (4b), welches zwischen dem Metallsubstrat und dem isolierenden Substrat bereitgestellt ist, wobei zumindest ein Teil des zweiten Verbindungselements sich zwischen dem zweiten Halbleiterchip und dem Metallsubstrat in der ersten Richtung befindet, wobei

der erste Halbleiterchip eine erste überlappende Region (OAa) beinhaltet, welche das erste Verbindungselement in der ersten Richtung überlappt, und

ein Bereich der ersten überlappenden Region in einer Schnittebene in der XY-Ebene, welche die erste Richtung kreuzt, 90 Prozent oder mehr von einem ersten Bereich des ersten Halbleiterchips in der Schnittebene ist, wobei das erste Verbindungselement ein erstes Verbindungsstück (4aa) und ein zweites Verbindungsstück (4ab) beinhaltet, **gekennzeichnet durch**

ein Harz (83), welches zwischen dem ersten Verbindungsstück und dem zweiten Verbindungsstück in der zweiten, X-, Richtung bereitgestellt ist.

2. Vorrichtung nach Anspruch 1, wobei eine erste Länge (L1) des ersten Halbleiterchips entlang der zweiten, X-, Richtung rechtwinkelig zu der ersten Richtung (Z) weniger als oder gleich einer zweiten Länge (L2) des ersten Verbindungselements entlang der zweiten Richtung ist.

3. Vorrichtung nach Anspruch 1 oder 2, wobei das erste Verbindungselement und das zweite Verbindungselement bei einer Dichte von 60 Prozent oder mehr und 95 Prozent oder weniger porös sind.

4. Vorrichtung nach einem der Ansprüche 1-3, wobei

eine erste Dicke (t1) entlang der ersten Richtung des ersten Verbindungselements 50 $\mu$m oder mehr und 200 $\mu$m oder weniger ist, und

eine zweite Dicke (t2) entlang der ersten Richtung des zweiten Verbindungselements 50 $\mu$m oder mehr und 200 $\mu$m oder weniger ist.

5. Vorrichtung nach einem der Ansprüche 1-4, wobei

eine erste Wärmeleitfähigkeit des ersten Verbindungselements 80 W/(m·K) oder mehr und 350 W/(m·K) oder weniger ist, und

eine zweite Wärmeleitfähigkeit des zweiten Verbindungselements 80 W/(m·K) oder mehr und 350 W/(m·K) oder weniger ist.

6. Vorrichtung nach einem der Ansprüche 1-5, wobei ein erster Bereich S1 des ersten Halbleiterchips in einer Schnittebene, welche die erste Richtung kreuzt, und ein zweiter Bereich S2 des ersten Verbindungselements in der Schnittebene einer Beziehung von

$1,0 \leq S2/S1 \leq 3,0$ entsprechen.

7. Vorrichtung nach Anspruch 6, wobei ein dritter Bereich S3 in der Schnittebene des zweiten Halbleiterchips und ein vierter Bereich S4 in der Schnittebene des zweiten Verbindungselements einer Beziehung von

$1,0 \leq S4/S3 \leq 3,0$ entsprechen.

8. Vorrichtung nach einem der Ansprüche 1-7, weiter umfassend:

ein Zwischenelement (80); und
ein Wärmeableitungselement (81),
wobei das Metallsubstrat zwischen dem ersten Verbindungselement und dem Zwischenelement und zwischen dem zweiten Verbindungselement und dem Zwischenelement bereitgestellt ist, und
das Zwischenelement zwischen dem Metallsubstrat und dem Wärmeableitungselement bereitgestellt ist.

9. Vorrichtung nach einem der Ansprüche 1-8, weiter umfassend:
ein Harz (83), welches zwischen dem ersten Verbindungselement und dem zweiten Verbindungselement in einer zweiten, x-, Richtung, welche die erste, Z-, Richtung kreuzt, bereitgestellt ist.

10. Vorrichtung nach Anspruch 1, wobei eine erste Länge (L1) des ersten Halbleiterchips entlang der zweiten Richtung rechtwinkelig zu der ersten Richtung länger als eine zweite Länge (L2) des ersten Verbindungselements entlang der einen Richtung ist.

**11.** Vorrichtung nach Anspruch 2, wobei die erste Länge L1, die zweite Länge L2 und eine erste Distanz D1 von dem ersten Halbleiterchip zu dem Metallsubstrat in der ersten Richtung einer Beziehung von L2 ≤ L1 + (D1×2) entsprechen.

**12.** Vorrichtung nach Anspruch 2, wobei eine dritte Länge (L3) entlang der zweiten Richtung des zweiten Halbleiterchips weniger als oder gleich einer vierten Länge (L4) entlang der einen Richtung des zweiten Verbindungselements ist.

**13.** Vorrichtung nach Anspruch 12, wobei die dritte Länge L3, die vierte Länge L4 und eine zweite Distanz D2 von dem zweiten Halbleiterchip zu dem Metallsubstrat in der ersten Richtung einer Beziehung von L4 ≤ L3 + (D2x2) entsprechen.

**14.** Vorrichtung nach Anspruch 2, wobei eine fünfte Länge L5 des ersten Halbleiterchips entlang einer Schnittrichtung, welche rechtwinkelig zu der ersten Richtung ist und die zweite Richtung kreuzt, weniger als oder gleich einer sechsten Länge (L6) des ersten Verbindungselements entlang der Schnittrichtung ist.

**15.** Vorrichtung nach Anspruch 14, wobei die fünfte Länge L5, die sechste Länge L6 und eine erste Distanz D1 von dem ersten Halbleiterchip zu dem Metallsubstrat in der ersten Richtung einer Beziehung von L6 ≤ L5 + (D1×2) entsprechen.

**16.** Vorrichtung nach Anspruch 14, wobei eine siebente Länge L7 entlang der Schnittrichtung des zweiten Halbleiterchips weniger als oder gleich einer achten Länge entlang der Schnittrichtung des zweiten Verbindungselements ist.

**17.** Vorrichtung nach Anspruch 16, wobei die siebente Länge L7, die achte Länge L8 und eine zweite Distanz D2 von dem zweiten Halbleiterchip zu dem Metallsubstrat in der ersten Richtung einer Beziehung von L7 ≤ L8 ≤ L7 + (D2x2) entsprechen.

**Revendications**

**1.** Dispositif à semi-conducteur (100) comprenant :

une première puce à semi-conducteur (1a) ;
une seconde puce à semi-conducteur (1b) ;
un substrat métallique (2) espacé de la première puce à semi-conducteur et de la seconde puce à semi-conducteur dans une première direction, Z, croisant une deuxième direction, X, à partir de la première puce à semi-conducteur jusqu'à la seconde puce à semi-conducteur, dans lesquelles la deuxième direction, X, est orthogonale à la première direction et à une troisième direction, Y ;
un substrat isolant (3) prévu entre la première puce à semi-conducteur et le substrat métallique et entre la seconde puce à semi-conducteur et le substrat métallique ;
un premier élément de liaison (4a) prévu entre le substrat métallique et le substrat isolant, au moins une partie du premier élément de liaison étant située entre la première puce à semi-conducteur et le substrat métallique dans la première direction ; et
un second élément de liaison (4b) prévu entre le substrat métallique et le substrat isolant, au moins une partie du second élément de liaison étant située entre la seconde puce à semi-conducteur et le substrat métallique dans la première direction, dans lequel
la première puce à semi-conducteur inclut une première région de chevauchement (OAa) chevauchant le premier élément de liaison dans la première direction, et une surface de la première région de chevauchement dans un plan d'intersection dans le plan XY croisant la première direction fait 90 pour cent ou plus d'une première surface de la première puce à semi-conducteur dans le plan d'intersection, dans lequel
le premier élément de liaison inclut une première pièce de liaison (4aa) et une seconde pièce de liaison (4ab), **caractérisé par**
une résine (83) prévue entre la première pièce de liaison et la seconde pièce de liaison dans la deuxième direction, X.

**2.** Dispositif selon la revendication 1, dans lequel une première longueur (L1) de la première puce à semi-conducteur le long de la deuxième direction, X, perpendiculaire à la première direction (Z) est inférieure ou égale à une deuxième longueur (L2) du premier élément de liaison le long de la deuxième direction.

3.  Dispositif selon la revendication 1 ou 2, dans lequel le premier élément de liaison et le second élément de liaison sont poreux à une densité de 60 pour cent ou plus et 95 pour cent ou moins.

4.  Dispositif selon l'une quelconque des revendications 1-3, dans lequel
    une première épaisseur (t1) le long de la première direction du premier élément de liaison est de 50 $\mu$m ou plus et 200 $\mu$m ou moins, et
    une seconde épaisseur (t2) le long de la première direction du second élément de liaison est de 50 $\mu$m ou plus et 200 $\mu$m ou moins.

5.  Dispositif selon l'une quelconque des revendications 1-4, dans lequel
    une première conductivité thermique du premier élément de liaison est 80 W/(m·K) ou plus et 350 W/(m·K) ou moins, et
    une seconde conductivité thermique du second élément de liaison est 80 W/(m·K) ou plus et 350 W/(m·K) ou moins.

6.  Dispositif selon l'une quelconque des revendications 1-5, dans lequel une première surface S1 de la première puce à semi-conducteur dans un plan d'intersection croisant la première direction et une deuxième surface S2 du premier élément de liaison dans le plan d'intersection satisfont à une relation de

$$1,0 \leq S2/S1 \leq 3,0.$$

7.  Dispositif selon la revendication 6, dans lequel une troisième surface S3 dans le plan d'intersection de la seconde puce à semi-conducteur et une quatrième surface S4 dans le plan d'intersection du second élément de liaison satisfont à une relation de

$$1,0 \leq S4/S3 \leq 3,0.$$

8.  Dispositif selon l'une quelconque des revendications 1-7, comprenant en outre :

    un élément intermédiaire (80) ; et
    un élément de dissipation de chaleur (81),
    dans lequel le substrat métallique est prévu entre le premier élément de liaison et l'élément intermédiaire et entre le second élément de liaison et l'élément intermédiaire, et
    l'élément intermédiaire est prévu entre le substrat métallique et l'élément de dissipation de chaleur.

9.  Dispositif selon l'une quelconque des revendications 1-8, comprenant en outre :
    une résine (83) prévue entre le premier élément de liaison et le second élément de liaison dans une seconde direction, x, croisant la première direction, Z.

10. Dispositif selon la revendication 1, dans lequel une première longueur (L1) de la première puce à semi-conducteur le long de la deuxième direction perpendiculaire à la première direction est plus longue qu'une deuxième longueur (L2) du premier élément de liaison le long d'une direction particulière.

11. Dispositif selon la revendication 2, dans lequel la première longueur L1, la deuxième longueur L2 et une première distance D1 allant de la première puce à semi-conducteur jusqu'au substrat métallique dans la première direction satisfont à une relation de

$$L2 \leq L1 + (D1 \times 2).$$

12. Dispositif selon la revendication 2, dans lequel une troisième longueur (L3) le long de la deuxième direction de la seconde puce à semi-conducteur est inférieure ou égale à une quatrième longueur (L4) le long de la direction particulière du second élément de liaison.

13. Dispositif selon la revendication 12, dans lequel la troisième longueur L3, la quatrième longueur L4 et une seconde distance D2 allant de la seconde puce à semi-conducteur jusqu'au substrat métallique dans la première direction satisfont à une relation de

$$L4 \leq L3 + (D2 \times 2).$$

14. Dispositif selon la revendication 2, dans lequel une cinquième longueur L5 de la première puce à semi-conducteur le long d'une direction d'intersection qui est perpendiculaire à la première direction et croisant la deuxième direction est inférieure ou égale à une sixième longueur (L6) du premier élément de liaison le long de la direction d'intersection.

15. Dispositif selon la revendication 14, dans lequel la cinquième longueur L5, la sixième longueur L6 et une première distance D1 allant de la première puce à semi-conducteur jusqu'au substrat métallique dans la première direction satisfont à une relation de

$$L6 \leq L5 + (D1 \times 2).$$

16. Dispositif selon la revendication 14, dans lequel une septième longueur L7 le long de la direction d'intersection de la seconde puce à semi-conducteur est inférieure ou égale à une huitième longueur le long de la direction d'intersection du second élément de liaison.

17. Dispositif selon la revendication 16, dans lequel la septième longueur L7, la huitième longueur L8 et une seconde distance D2 allant de la seconde puce à semi-conducteur au substrat métallique dans la première direction satisfont à une relation de

$$L7 \leq L8 \leq L7 + (D2 \times 2).$$

FIG. 1

FIG. 2A

FIG. 2C

FIG. 2B

# FIG. 3A

# FIG. 3C

FIG. 3B

FIG. 4

FIG. 5

FIG. 6A

FIG. 6B

EP 3 392 907 B1

FIG. 7

25

FIG. 8A

FIG. 8C

FIG. 8B

FIG. 8D

FIG. 9

3   5a  1a(1b)

OAa  OAb  OAc  OAd

$S_{OAa}$

$S_{NOAa}$

$S_{OAb}$

$S_{NOAb}$

B

$S_{OAc}$

$S_{OAd}$

$S_{NOAc}$

B

Y

Z⊙→X

NOAa  NOAb  NOAc

4aa      4ab      4ac      4ad
(4ba)   (4bb)   (4bc)   (4bd)

FIG. 10A

1a(1b)

5a

3

5d

2

Z

Y⊗→X

4aa      4ab      4ac      4ad
(4ba)   (4bb)   (4bc)   (4bd)

FIG. 10B

FIG. 11

FIG. 12

**EP 3 392 907 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012138946 A1
- JP 2016134586 A